# EUROPEAN PATENT SPECIFICATION

(11) **EP 2 791 985 B1**
(45) Date of publication and mention of the grant of the patent: **28.02.2018**
(21) Application number: 12797975.5
(22) Date of filing: 09.10.2012
(51) Int. Cl.: H01L 41/18, H01L 41/37

(54) **METHOD FOR INSERTING OR DISPERSING PARTICLES WITH PIEZOELECTRIC PROPERTIES INSIDE A LAYER**
VERFAHREN ZUM EINBRINGEN ODER STREUEN VON TEILCHEN MIT PIEZOELEKTRISCHEN EIGENSCHAFTEN IN EINER SCHICHT
PROCÉDÉ PERMETTANT D'INSÉRER OU DE DISPERSER DES PARTICULES PRÉSENTANT DES PROPRIÉTÉS PIÉZOÉLECTRIQUES À L'INTÉRIEUR D'UNE COUCHE

(30) Priority: 12.10.2011 WO PCT/IB2011/054507; 19.11.2011 WO PCT/IB2011/055194
(43) Date of publication of application: 22.10.2014
(73) Proprietor: SPF Logica S.r.l., 31044 Montebelluna (TV) (IT)
(72) Inventor: EBERLE, Giorgio, I-31044 Montebelluna (TV) (IT); CAPPELLI, Fabio, I-31044 Montebelluna (TV) (IT); PARONETTO, Giuseppe, I-31044 Montebelluna (TV) (IT)
(74) Representative: Citron, Massimiliano
(86) International application number: PCT/IB2012/055455
(87) International publication number: WO 2013/054259

(56) References cited:
- US-A- 4 595 515
- US-A- 6 081 979
- ALESHIN A N ET AL: "Switching and memory effects governed by the hopping mechanism of charge carrier transfer in composite films based on conducting polymers and inorganic nanoparticles", PHYSICS OF THE SOLID STATE, vol. 50, no. 10, October 2008 (2008-10), pages 1978-1984, XP055052356, ISSN: 1063-7834, DOI: 10.1134/S1063783408100314

## Description

The invention relates to a process or method for inserting or dispersing particles with piezoelectric properties, e.g. quartz particles, within a layer or substrate (preferably containing polarisable polymers) modifiable by an electromagnetic field to vary its electrical resistivity, from an insulator to a conductor or vice versa. The invention also relates to the substrate obtained. In other patent applications, such as non-prepublished WO 2011/125037 A2, to which we refer to, the applicant described a substrate or paint polarisable for example by means of laser, wherein some quartz is dispersed so as to also confer piezoelectric properties to the paint.

When subjected to an external force the quartz is able to generate an electric signal (voltage and current) which by means of conductive tracks made in the paint is propagated where desired. The quartz itself can apply a force to the paint or substrate if electrically supplied with opportune pulses via the aforementioned tracks. The document in PHYSICS OF THE SOLID STATE, vol. 50, no. 10, October 2008, pages 1978-1984 discloses composite films with electric field switchable resistance, comprising e.g. ZnO nanoparticles dispersed in thiophene derivatives. The problem remains of how to conveniently insert particles with piezoelectric effect, like the aforementioned quartz, in the paint or substrate to achieve the desired effects.

The invention sets out to solve this problem by the method defined in claim 1.

When using quartz, it is advantageous to disperse in a matrix or substrate, preferably of solvent, sintered material containing quartz, known as "loaded quartz", that is provided with micro-electrodes, preferably metallic, to collect or send electric charges. A process for loading quartz involves sublimating two conductor sheets above and below a layer of quartz at high temperature (about 700°C), sintering it at 1000°C and then cooling to about 200°C to then expose it to an electric field of about 3000V/cm so as to position all the quartz particles with the electrodes parallel and alongside each other. A sandwich structure of oriented quartz placed between two conductor sheets results.

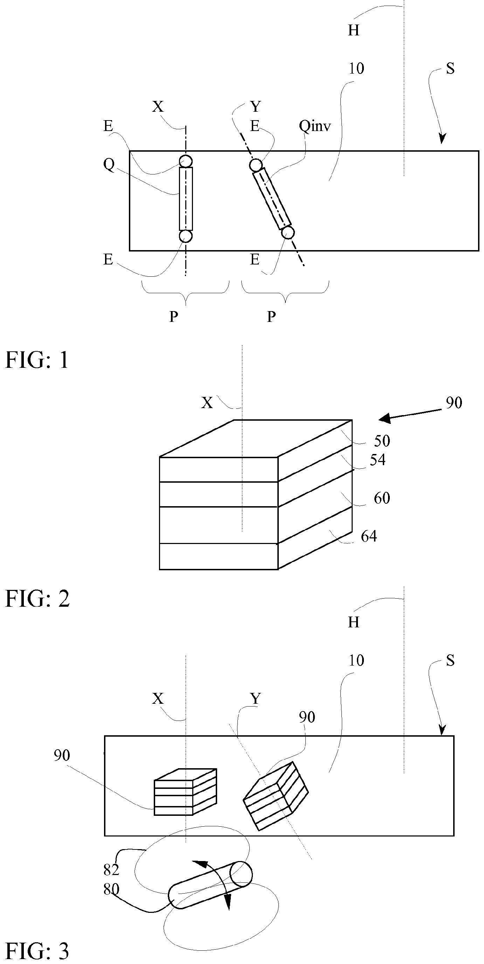

According to the inventive concept, such sandwich is ground to form particles of quartz P (see Fig. 1) small as desired which each have two electrodes E. The particles P are then dispersed in the substrate.

The quartz alone is really just an example of embodiment for the piezoelectric component of the particle. Any material with piezoelectric properties can replace the quartz. In particular it proved advantageous to use particles with PZT inside, since its Pb and Ti components act as counter-electrode to the component of quartz inside the PZT.

Generally speaking, another problem is then the orientation of said particles with piezoelectric features. See Fig. 1 which shows for instance particles of oriented quartz compared to each other. Especially when the quartz or PZT generates charge pulses following a pulsating force or load, the maximum energy yield is only achieved if the quartz or PZT is oriented parallel to the direction of the pulsating force. That is to say that the micro-electrodes of each particle of quartz or PZT should align with the line of action of the force, so as to receive the maximum component thereof. In addition, each application may require different orientations. For example, if the loading force is a vehicle and the substrate is laid on the road, it is clear that the quartzes or PZT should preferably be inclined relative to the orthogonal to the road surface towards the incoming vehicle. Only this way the component resulting from the movement impressed on the substrate is exploited.

The sintering technique described above may at most produce (see Fig. 1, left) quartz Q dispersed in a substrate 10 which has two electrodes Ewhose axis X is oriented substantially orthogonal to the main surface S of the substrate 10 (parallel to the line H orthogonal to S).

The invention sets out to solve this problem by the method as characterised in claim 4, in which a method is defined for orienting particles having piezoelectric properties dispersed within a layer of material modifiable by an electromagnetic field to vary its electrical resistivity, from an insulator to a conductor or vice versa, characterized by striking the particles with a magnetic field to orient them.

Not only does the use of a magnetic field enable to orient all the particles Qinv (see Fig. 1 to the right or Fig. 3 particles 90 to the left) in whatever orientation desired (Y axis), but this happens even at very low temperatures, e.g. maximum 150 °C, at which the substrate is still in a gelatinous form and not dry, and does not risk deterioration as a result of the high temperature. The prior art, instead, applying an electric field to a solid sandwich and not a fluid substrate, requires heating of the material to a high temperature, with consequent deterioration problems. The axis X of the particles Qinv, 90 can be oriented at will simply by directing the magnetic field in the desired direction. The particles Qinv, 90 are floating in the substrate 10 yet to solidify and rotate to orient themselves without much opposition.

It is, anyway, possible to use both the methods expounded above, either separately or combined.

The solution to orient the particles by a magnetic field can be used also for those containing PZT instead of quartz, with an improvement that is obtained by inserting into the particle structure (see fig. 2 particle 90) a layer of any ferromagnetic metal (with 1 to 4 free electrons). The particle 90 is formed by an inner layer 60 of PZT, on which is placed a layer or component 54 of ferromagnetic metal, e.g. iron which is inexpensive. The structure is placed between two outer electrically conductive layers 50, 64, e.g. of metal, e.g. silver. For the layer 54 e.g. also ferrite or cobalt-ferrite or a generic ferrous structure may be used. The layers 50, 64 serve to collect the charges generated in the PZT or to lead an electrical signal to the particle 90.

Note that also the structure of the particle 90 is innovative.

The layer or component 54 can be inserted into the particle 90 after having built the layers 50, 60, 64 e.g. by diffusion in Edwards cell or by electronic bonding.

The particle 90 is preferably approximately a cube, e.g. having a side equal to 50 µm, optimally equal to 10-20 µm. Such thicknesses are well suited to be covered by thin layers of substrate 10 sprayed or laid with a brush. The cube shape is obtained by cutting a wafer e.g. of 1cm x 1 cm x 50 µm.

The particle 90 in laboratory has provided about 140 pC/N² (on an area of 1/20 mm).

The magnetic field may be continuous, but if it is alternating, generated e.g. with an induction coil, at frequencies e.g. in the order of kHz, it is more advantageous because it periodically induces on the particles an orienting momentum, and period after period it can orient the quartz without stress on the material.

To definitively stabilise the configuration of the particles of loaded quartz, a simple and efficacious way is to expose the substrate to UV radiation. As UV one can use the general type, for example those used to dry paints.

A method for orienting the said particles, e.g. those indicated with 90 (see fig. 3), can be the following.

After randomly dispersing the particles 90 in the still liquid substrate 10 (in Fig. 3 same references as in fig. 1 or 2 have the same meaning as above) one can intervene with a magnetic field source 80 (e.g. as that for the quartz) adapted to generate in the surrounding space lines of force 82. By translating and/or rotating the source 80 the axes of the particles 90 are varied to bring them from the configuration with Y axis to the one with X axis, in which the lying planes of the layers 50, 60, 64 are substantially (or nearly) parallel to the surface S.

A variation is to change the orientation of the axes Y when the substrate 10 is solidified or is solid. The substrate 10 can be softened by heating, e.g. by means of a laser beam out of focus, and then operate with the source 80 as already said above. After removing the source that brings heat, the substrate 10 re-solidifies with the particles oriented inside. The advantage of using a laser, besides keeping cost limited, is the precision with which the area of softening is defined, thereby being able to intervene locally with desired resolution in the substrate 10.

The said substrate or matrix which contains all the dispersed elements which we will describe below may generically be a solvent, preferably aromatic. In particular use of a benzene is preferred, and preferably a dichlorobenzene (because it dissolves Thiophene well), a dichloromethane or a nitro type diluent.

Note that as a paint or substrate it is sufficient to use in general a substrate modifiable from the outside, e.g. via an electromagnetic field or laser, to vary its electrical resistivity, from an insulator to conductor or vice versa. In this way one can create conductive tracks inside the substrate to bring, transfer or receive signal (voltage or current) to said piezoelectric particles.

Along with metal oxides in the substrate there may be a further component such as e.g a graphite. The graphites are excellent dopants, primarily for their high electrical conductivity. Peculiar graphite subfamilies which proved to be very advantageous, because said qualities are accentuated, are the fullerene and graphene.

The metal oxides may be:
- freely dispersed in a random manner inside a painting matrix based of, for example, vinyl-acetate or vinyl -ester, or
- dispersed also in a matrix of polymers with conjugated covalent double bond, that is to say heterocyclic compounds, formed of n atoms of carbon and one atom of a different type bound according to a ring structure.

One advantageous family of these polymers is Butadiene, which has a very stable molecule.

Another advantageous family of polymers is Thiophene or polythiophene, which substitutes the vinyl. The molecules of Thiophene have the marked characteristic, as will be seen later, of positioning themselves in a laminar manner, that is to say all on a plane without overlapping. In addition the sulphur atom of Thiophene has many electronic affinities with the matrix. In fact Thiophene has a free atom of Sulphur which acts as a binding agent among the monometric chains during polymerisation.

Thiophene and Butadiene can also be mixed together in the matrix.

The aforesaid polymers and graphites can co-operate together in the matrix with the metal oxides. Note however that one or more of said polymers may also be used alone in the matrix without the aid of the oxides and/or in their substitution (everything described for the rest of the substrate still applying).

Iron chloride or aluminium chloride, with or without colouring pigments, may be added to the metal oxides plus the polymers or when they are alone to only one of the two. Such chlorides are strong dopants, and are convenient both because they eliminate a hysteretic phenomenon which will be spoken of below and because they have a marked capacity to release/accept electrons. In particular the iron chloride or aluminium chloride are oxides dissolved in chlorine which dissolves well in thiophene, which is a plastic. The excellent homogenisation ensures excellent communication at an electronic level, which favours the interchange of electrons towards the polymer (e.g. thiophene).

The metal oxides may, for example, consist of iron oxides in the formulation Fe₂O₃ or Fe₃O₄ or even better, for an improved magnetisation/ saturation curve, by chrome oxides or dioxides, in the formulation CrO₂.

The metal oxides, with the optional graphite, and/or the optional polymers will be dispersed in the painting matrix or substrate.

The mixture of paint may be loaded with the metal oxides, or also with only one or several of said polymers, preferably Thiophene, and as said with some quartz (one or more of its 19 families), in particular BaTiO₃ or PbTiO₃. A component with TiO₃ has the advantage of being very gripping, does not dry and also is able to make free electrons available with little energy.

As said, signals or current may be generated locally on the same paint or substrate or matrix by compressing it with a finger or any element or weight, or other system. With a laser beam there are created conductive tracks to collect from the electrodes of the particles QInv or 90 electrical signals, or to feed with the latter the electrodes.

One can use also quartz with greater granulometry to increase the substrate's conductivity. However the quartz dispersed in the matrix, in particular a thiophenic matrix, may constitute an obstacle to tracing the conductive tracks. In fact quartz does not conduct and a track would be interrupted. This problem is solved by providing a layer of matrix with loaded quartz laid over a layer without it. In particular a first substrate composed as described is spread, then a second is spread over the first substrate when it has dried. Said particles of charged quartz are then dispersed in the second substrate, and they are given a specific spatial orientation where necessary. In the end the two layers appear as a single block.

## Claims

1. Method for inserting or dispersing particles (P, 90) with piezoelectric properties within a substrate (10) modifiable by an electromagnetic field to vary its electric resistivity, from insulator to conductor and vice versa, **characterised by** the fact that
- in the substrate particles (P; 90) are dispersed, the particles comprising in a sandwich structure two conductor layers (E; 50, 64) and a layer of material with piezoelectric properties (Qinv; 60) in the middle.

2. Method according to claim 1, wherein a sintered material, comprising in a sandwich structure two conductor layers (E) and a quartz layer (Qinv) in the middle, is ground to obtain said particles.

3. Method according to claim 1, wherein the material with piezoelectric properties is PZT.

4. Method according to claim 1 or 2 or 3, wherein
- the particles (P; 90) dispersed in the substrate are spatially orientated by means of a magnetic field.

5. Method according to claim 1 or 2 or 3 or 4, wherein the magnetic field is an alternate magnetic field

6. Method according to any of the previous claims, wherein a substrate (10) is used containing a polymer with conjugated covalent double bond, that is to say a heterocyclic compound formed of n atoms of carbon and one atom of a different type bound in a ring structure.

7. Method according to claim 6, comprising Thiophene and/or a polythiophene and/or a Butadiene as polymer.

8. Method according to any of the previous claims, wherein
- a substrate made according to any of the previous claims is spread out,
- a second substrate, made according to any of the previous claims, is spread over the first substrate when the latter has dried;
- said particles are dispersed in the second substrate.

9. Method according to any one of the preceding claims, wherein to the particles a layer (54) of a ferromagnetic metal is associated.

10. Compound comprising
- a substrate (10), and
- a dispersion in the substrate comprising
o a material adapted to change from insulator to conductor and vice versa when struck by an electromagnetic field, and
∘ particles (P; 90) provided with two electrodes (E; 54, 60) and an intermediate layer of material with piezoelectric properties (Qinv; 60) which is adapted to donate or receive electrical charges to/from the substrate by piezoelectric effect.

11. Compound according to claim 10, wherein the geometric axes (Y) passing through the electrodes of said particles substantially all have the same spatial orientation.

12. Compound according to claim 11, wherein the substrate extends mainly along a surface (S) and said axes (Y) are inclined relative to the orthogonal (H) to such surface (S).

13. Compound according to any one of the claims 10 to 12, comprising a second substrate of solvent laid over the first, the second substrate being configured according to any of the claims 10 to 13 but without said particles.

14. Compound according to any one of claims 10 to 13, wherein the material with piezoelectric properties is PZT.

15. Compound according to any one of claims 10 to 14, wherein a layer of a ferromagnetic metal is associated with the particles.

## Patentansprüche

1. Verfahren zum Einbringen oder Dispergieren von Partikeln (P, 90) mit piezoelektrischen Eigenschaften in ein Substrat (10), das durch ein elektromagnetisches Feld modifizierbar ist, um seinen elektrischen Widerstand von Isolator zu Leiter oder umgekehrt zu verändern, **dadurch gekennzeichnet, dass**
- im Substrat (P; 90) Partikel dispergiert werden, die in einer Sandwichstruktur zwei leitfähige Schichten (E; 50,64) und eine Materialschicht mit piezoelektrischen Eigenschaften (Qinv; 60) in der Mitte umfassen.

2. Verfahren nach Anspruch 1, bei dem ein gesintertes Material, das aus zwei leitenden Schichten (E) und einer Schicht aus Quarz (Qinv) in der Mitte in einer Sandwichstruktur besteht, gemahlen wird, um diese Partikel zu erhalten.

3. Verfahren nach Anspruch 1, bei dem das Material mit piezoelektrischen Eigenschaften PZT ist.

4. Verfahren nach Anspruch 1 oder 2 oder 3, bei dem
- sich die im Substrat dispergierten Partikel (P; 90) durch ein Magnetfeld räumlich ausrichten.

5. Verfahren nach Anspruch 1 oder 2 oder 3 oder 4, bei dem das Magnetfeld ein magnetisches Wechselfeld ist.

6. Verfahren nach einem der oben genannten Ansprüche, wobei ein Substrat (10) verwendet wird, das ein konjugiertes kovalentes Doppelbindungspolymer enthält, d. h. eine heterozyklische Verbindung, die aus n Kohlenstoffatomen und einem Atom eines anderen Typs besteht, die in einer Ringstruktur gebunden sind.

7. Verfahren nach Anspruch 6, das als Polymer Thiophen und/oder Polythyophen und/oder Butadien enthält.

8. Verfahren nach einem der oben genannten Ansprüche, bei dem
- ein erstes nach einem der vorhergehenden Ansprüche hergestelltes Substrat aufgetragen wird,
- ein zweites nach einem der vorhergehenden Ansprüche hergestelltes Substrat auf das erste Substrat aufgetragen wird, nachdem dieses getrocknet ist;
- im zweiten Substrat diese Partikel dispergiert werden.

9. Verfahren nach einem der oben genannten Ansprüche, bei dem eine Schicht (54) aus ferromagnetischem Metall mit den Partikeln assoziiert ist.

10. Verbindung, bestehend aus
- einem Substrat (10), und
- einer Dispersion im Substrat, bestehend aus
- einem Material, das bei Einwirkung eines magnetischen oder elektromagnetischen Felds von Isolator zu Leiter und umgekehrt wechseln kann, und
- Partikel (P, 90), die mit zwei Elektroden (E; 50, 64) und einer Zwischenschicht aus Material mit piezoelektrischen Eigenschaften (Qinv; 60) ausgestattet sind, die geeignet ist, elektrische Ladungen aufgrund eines piezoelektrischen Effekts an das Substrat abzugeben oder von ihm zu empfangen.

11. Verbindung nach Anspruch 10, in der die geometrischen Achsen (Y) durch die Elektroden dieser Partikel im Wesentlichen alle die gleiche räumliche Orientierung haben.

12. Verbindung nach Anspruch 11, in der sich das Substrat hauptsächlich entlang einer Oberfläche (S) erstreckt und diese Achsen (Y) gegenüber der Senkrechten (H) zu dieser Oberfläche (S) geneigt sind.

13. Verbindung nach einem der Ansprüche von 10 bis 12, bestehend aus einem zweiten Lösungsmittelsubstrat, das auf dem ersten aufgetragen ist, wobei das zweite Substrat gemäß einem der Ansprüche von 10 bis 13 konfiguriert ist, jedoch ohne solche Partikel.

14. Verbindung nach einem der Ansprüche von 10 bis 13, bei dem das Material mit piezoelektrischen Eigenschaften PZT ist.

15. Verbindung nach einem der Ansprüche von 10 bis 15, bei dem eine Schicht aus ferromagnetischem Metall mit den Partikeln assoziiert ist.

## Revendications

1. Méthode pour insérer ou disperser des particules (P, 90) à propriétés piézoélectriques à l'intérieur d'un substrat (10), modifiable par un champ électromagnétique pour faire varier sa résistance électrique, d'isolant à conducteur ou inversement, **caractérisé par le fait que**
sont dispersées dans le substrat des particules (P, 90) à structure sandwich composées de deux couches conductrices (E; 50, 64), de chaque côté d'une couche en matériau doté de propriétés piézoélectriques (Qinv,; 60).

2. Méthode selon la proposition 1 dans laquelle, pour obtenir lesdites particules, on broie un matériau fritté à structure sandwich composé de deux couches conductrices (E) de part et d'autre d'une couche de quartz (Qinv).

3. Méthode selon la proposition 1, dans lequel le matériau à propriétés piézoélectriques est le PZT.

4. Méthode selon la proposition 1 ou 2 ou 3 dans laquelle
on oriente les particules (P; 90) dispersées dans le substrat au moyen d'un champ magnétique.

5. Méthode selon la proposition 1 ou 2 ou 3 ou 4, dans laquelle le champ magnétique est un champ magnétique alterné.

6. Méthode selon l'une quelconque des propositions précédentes, dans laquelle on utilise un substrat (10) contenant un polymère à double liaison covalente conjuguée, c'est-à-dire un composé hétérocyclique constitué de n atomes de carbone et d'un atome d'un type différent, liés dans une structure en anneau.

7. Méthode selon la proposition 6, comprenant comme polymère le Tiophène et/ou un polytiophène et/ou un Butadiène.

8. Méthode selon l'une quelconque des propositions précédentes, dans laquelle
- on étend un premier substrat, réalisé selon l'une quelconque des propositions précédentes,
- on étend un second substrat, réalisé selon l'une quelconque des propositions précédentes, sur le premier substrat une fois que celui-ci est sec ;
- On disperse dans le second substrat lesdites particules.

9. Méthode selon l'une quelconque des propositions précédentes, dans laquelle on associe aux particules une couche de métal ferromagnétique.

10. Composé comprenant
- un substrat (10), et
- une dispersion dans le substrat comprenant
- un matériau capable de modifier ses propriétés, d'isolant à conducteur et inversement, lorsqu'il est heurté par un champ magnétique ou électromagnétique, et
- des particules (P, 90) dotées de deux électrodes (E; 50, 64) et d'une couche intermédiaire d'un matériau doté de propriétés piézoélectriques (Qinv; 60) capable de donner ou recevoir des charges électriques à/depuis le substrat à l'effet piézoélectrique.

11. Composé selon la proposition 10, dans lequel les axes géométriques (Y) passant par les électrodes desdites particules ont tous sensiblement la même orientation spatiale.

12. Composé selon la proposition 11, dans lequel le substrat s'étend de manière prédominante le long d'une surface (S) et lesdits axes (Y) sont inclinés par rapport à l'orthogonale (H) à cette surface (S).

13. Composé selon l'une quelconque des propositions de 10 à 12 comprenant un second substrat de solvant superposé au premier, le second substrat étant configuré selon l'une quelconque des propositions 10 à 13, mais sans lesdites particules.

14. Composé selon l'une quelconque des propositions de 10 à 13, dans lequel le matériau à propriétés piézoélectriques est le PZT.

15. Composé selon l'une quelconque des propositions de 10 à 15, dans lequel est associée aux particules une couche de métal ferromagnétique.
